# EUROPEAN PATENT SPECIFICATION

(11) **EP 4 425 950 B1**
(45) Date of publication and mention of the grant of the patent: **12.08.2026**
(21) Application number: 24153714.1
(22) Date of filing: 24.01.2024
(51) Int. Cl.: H04N 25/62, H04N 25/773, H04N 25/621

(54) **PHOTOELECTRIC CONVERSION DEVICE, CONTROL METHOD FOR PHOTOELECTRIC CONVERSION DEVICE, AND STORAGE MEDIUM**
PHOTOELEKTRISCHE UMWANDLUNGSVORRICHTUNG, STEUERUNGSVERFAHREN FÜR DIE PHOTOELEKTRISCHE UMWANDLUNGSVORRICHTUNG UND SPEICHERMEDIUM
DISPOSITIF DE CONVERSION PHOTOÉLECTRIQUE, PROCÉDÉ DE COMMANDE POUR DISPOSITIF DE CONVERSION PHOTOÉLECTRIQUE, ET SUPPORT DE STOCKAGE

(30) Priority: 28.02.2023 JP 2023029181
(43) Date of publication of application: 04.09.2024
(73) Proprietor: CANON KABUSHIKI KAISHA, Tokyo 146-8501 (JP)
(72) Inventor: NUMATA, Aihiko, Ohta-ku, Tokyo 146-8501 (JP); SANDO, Ryota, Ohta-ku, Tokyo 146-8501 (JP)
(74) Representative: TBK

(56) References cited:
- EP-A1- 3 657 775
- US-A1- 2022 344 521
- AULL BRIAN F ET AL: "A Study of Crosstalk in a $256 \times 256$ Photon Counting Imager Based on Silicon Geiger-Mode Avalanche Photodiodes", IEEE SENSORS JOURNAL, IEEE, USA, vol. 15, no. 4, 1 April 2015 (2015-04-01), pages 2123 - 2132, XP011571523, ISSN: 1530-437X, [retrieved on 20150127], DOI: 10.1109/JSEN.2014.2368456

## Description

### BACKGROUND OF THE INVENTION

### Field of the Invention

The present invention relates to a photoelectric conversion device, a control method for a photoelectric conversion device, a storage medium, and the like.

### Description of the Related Art

In recent years, photoelectric conversion devices digitally counting the number of photons that arrive at an avalanche photodiode (APD) and outputting counted values from pixels as photoelectrically converted digital signals have been proposed.

It is known that a phenomenon such as avalanche luminescence occurs in photoelectric conversion devices having an APD (Non-Patent Document 1). When avalanche luminescence occurs, the number of counts of adjacent pixel values increases due to generated secondary electrons incident on adjacent pixels, resulting in erroneous counting.
[Non-Patent Document 1] I. Rech et al., "Optical crosstalk in single photon avalanche diode arrays: a new complete model", OpEx 16 (12), 2008
Further prior art documents are EP 3 657 775 A1 showing a photoelectric conversion device, method of driving photoelectric conversion device, imaging system, and moving body, US 2022/344521 A1 showing a light detecting device and system and AULL BRIAN F ET AL:"A Study of Crosstalk in a 256 times 256 Photon Counting Imager Based on Silicon Geiger-Mode Avalanche Photodiodes", IEEE SENSORS JOURNAL, IEEE, USA, vol. 15, no. 4, 1 April 2015 (2015-04-01), pages 2123-2132.

### SUMMARY OF THE INVENTION

An photoelectric conversion device according to an aspect of the present invention is defined by claim 1.

Further features of the present invention will become apparent from the following description of embodiments with reference to the attached drawings.

### BRIEF DESCRIPTION OF THE DRAWINGS

FIG. 1 is a view showing an example of a constitution of a photoelectric conversion element of First Embodiment.
FIG. 2 is a view showing an example of a constitution of a sensor board of First Embodiment.
FIG. 3 is a view showing an example of a constitution of a circuit board of First Embodiment.
FIG. 4 is a view showing a timing chart of a vertical scanning circuit of First Embodiment.
FIG. 5 is a view showing a pixel and an equivalent circuit of a signal processing circuit corresponding to the pixel of First Embodiment.
FIG. 6 is a view schematically showing a relationship between operation of an APD of First Embodiment and an output signal.
FIG. 7 is a functional block diagram of a photoelectric conversion device of First Embodiment.
FIG. 8 is an explanatory view of luminous crosstalk when simultaneous multiple-row reading is performed.
FIG. 9 is an explanatory view of deterioration in image quality due to erroneous counting caused by luminous crosstalk.
FIG. 10 is an explanatory view of an influence of a length of an exposure time on deterioration in image quality.
FIG. 11 is another explanatory view of an influence of the length of the exposure time on deterioration in image quality.
FIG. 12 is an explanatory view of a relationship between the exposure time and an influence of luminous crosstalk.
FIG. 13 is an explanatory view of shutter linearity of the photoelectric conversion element of Second Embodiment.
FIG. 14 is a view showing a photoelectric conversion system of Third Embodiment.

### DESCRIPTION OF THE EMBODIMENTS

Hereinafter, with reference to the accompanying drawings, favorable modes of the present invention will be described using Embodiments. In each diagram, the same reference signs are applied to the same members or elements, and duplicate description will be omitted or simplified.

### <First Embodiment>

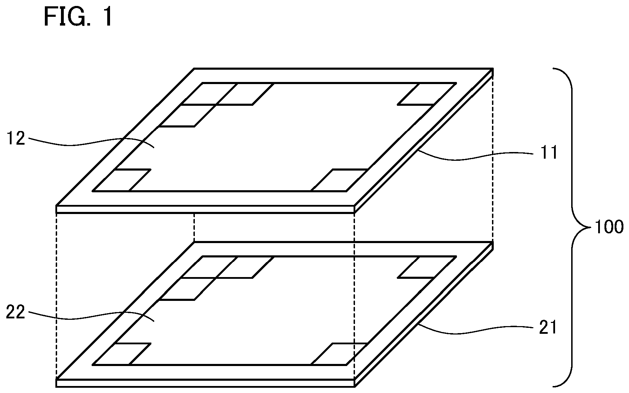

FIG. 1 is a view showing an example of a constitution of a photoelectric conversion element of First Embodiment. Hereinafter, a photoelectric conversion device having a so-called laminated structure constituted of a photoelectric conversion element 100 in which two boards such as a sensor board 11 and a circuit board 21 are laminated and electrically connected to each other will be described as an example. The photoelectric conversion element 100 may have a so-called non-laminated structure in which a constitution included in a sensor board and a constitution included in a circuit board are arranged in a common semiconductor layer. The sensor board 11 includes a pixel region 12. The circuit board 21 includes a circuit region 22 for processing a signal detected in the pixel region 12.

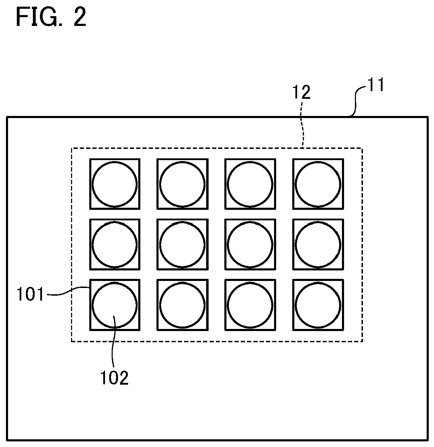

FIG. 2 is a view showing an example of a constitution of the sensor board 11 of First Embodiment. The pixel region 12 of the sensor board 11 includes a plurality of pixels 101 disposed in a two-dimensional shape in directions along multiple rows and columns. The pixels 101 are each provided with a photoelectric conversion unit 102 including an avalanche photodiode (hereinafter, an APD). The photoelectric conversion unit 102 converts light into an electrical signal. Specifically, an optical image formed by an image formation optical system 301 (which will be described below) is photoelectrically converted into an electrical signal. The number of rows and the number of columns of a pixel array forming the pixel region 12 are not particularly limited.

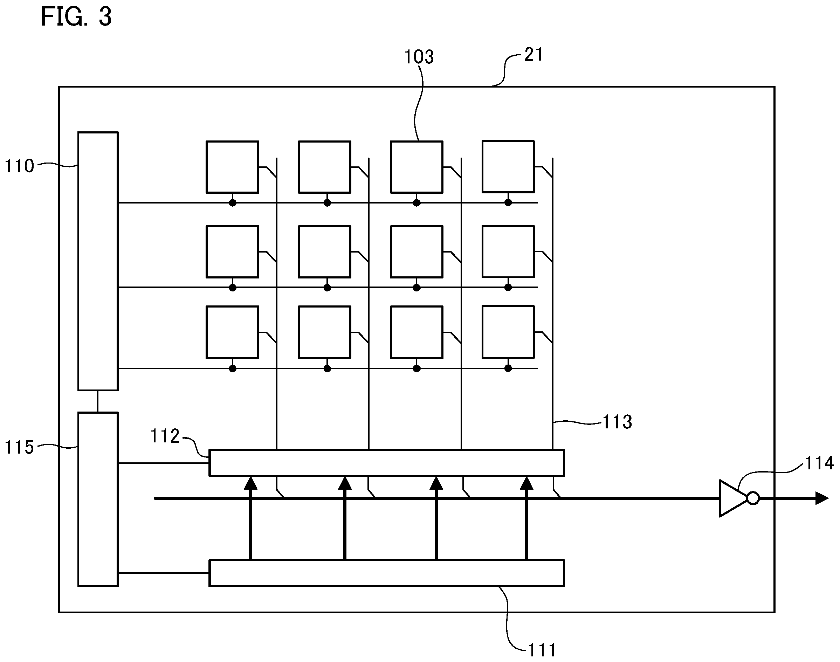

FIG. 3 is a view showing an example of a constitution of the circuit board 21 of First Embodiment. The circuit board 21 has signal processing circuits 103 for processing electric charge photoelectrically converted by the photoelectric conversion unit 102 shown in FIG. 2, a reading circuit 112, a control pulse generation unit 115, a horizontal scanning circuit 111, signal lines 113, and a vertical scanning circuit 110. A signal output from each photoelectric conversion unit 102 of the pixel is processed by the signal processing circuit 103. The signal processing circuits 103 are each provided with a counter, a memory, and the like, and the memory retains digital values.

In order to read a signal from the memory of each pixel in which digital signals are retained, the horizontal scanning circuit 111 inputs a control pulse for sequentially selecting each of the columns to the signal processing circuits 103. For the selected column, a signal is output to the signal line 113 from the signal processing circuit 103 of the pixel selected by the vertical scanning circuit 110. A signal output to the signal line 113 is output to the outside of the photoelectric conversion element 100 via an output circuit 114.

As shown in FIGS. 2 and 3, a plurality of signal processing circuits 103 are arranged in a region overlapping the pixel region 12 in a plan view. Further, in a plan view, the vertical scanning circuit 110, the horizontal scanning circuit 111, the reading circuit 112, the output circuit 114, and the control pulse generation unit 115 are arranged in an overlapping manner between an end of the sensor board 11 and an end of the pixel region 12. In other words, the sensor board 11 has the pixel region 12 and a non-pixel region arranged around the pixel region 12. Further, the vertical scanning circuit 110, the horizontal scanning circuit 111, the reading circuit 112, the output circuit 114, and the control pulse generation unit 115 are arranged in a region overlapping the non-pixel region in a plan view.

The vertical scanning circuit 110 receives a control pulse supplied from the control pulse generation unit 115 and supplies a control pulse to each pixel. The vertical scanning circuit 110 is constituted of a shift register or an address decoder in which a plurality of rows is connected as one unit, and high-speed reading is realized by reading the plurality of rows all at once. Particularly, in the case of a photoelectric conversion device in which the numbers of photons that arrive at the APDs are digitally counted and counted values are output from the pixels as photoelectrically converted digital signals, it will take time to operate counter circuits which digitally count the numbers of photons. For this reason, it is preferable to simultaneously read a plurality of rows for high-speed reading. That is, the vertical scanning circuit 110 which functions as a reading circuit for reading pixel signals from the pixels simultaneously reads pixel signals from the pixels included in the plurality of rows of the pixel region 12.

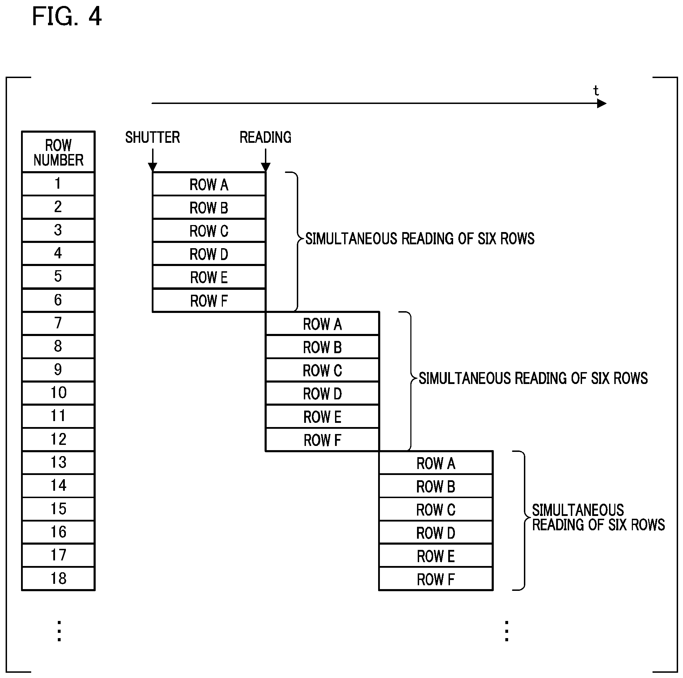

FIG. 4 is a view showing a timing chart of the vertical scanning circuit 110 of First Embodiment. Hereinafter, as shown in FIG. 4, when the rows to be simultaneously read are regarded as one group, the rows are discriminated based on positions of the rows within the group, and they are expressed as rows A to F. FIG. 4 shows a case in which there are six rows to be simultaneously read, but this is merely an example and the rows are not limited to six. In addition, FIG. 4 shows a case in which there are only six rows to be subjected to simultaneous exposure operation, but when an exposure time is long, the number of rows to be subjected to simultaneous exposure operation becomes an integer multiple of six rows. A difference caused by the exposure time will be described below.

Disposition of the signal lines 113 and disposition of the reading circuit 112 and the output circuit 114 are not limited to those in FIG. 3. For example, the signal lines 113 may extend and be arranged in the row direction, and the reading circuit 112 may be disposed at a place to which the signal lines 113 extend. In addition, the function of a signal processing unit does not necessarily have to be provided in every photoelectric conversion unit, and a constitution in which one signal processing unit is shared by a plurality of photoelectric conversion units and signal processing is sequentially performed may be adopted.

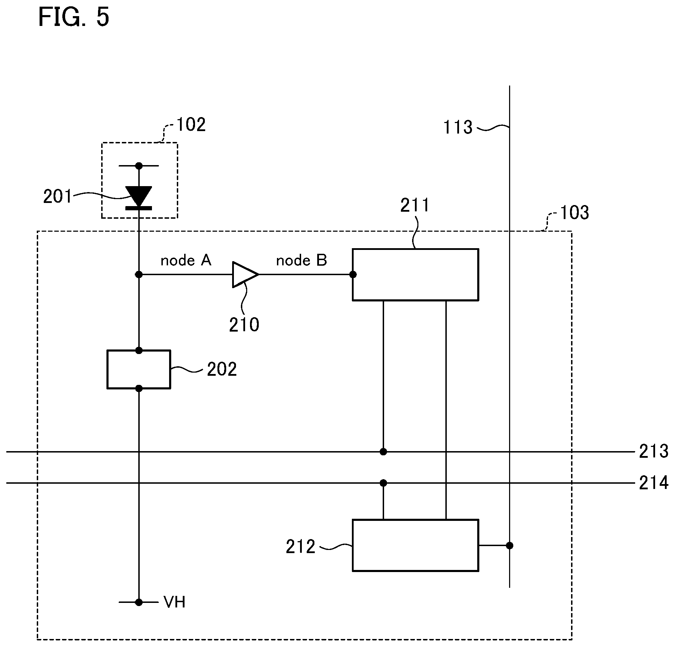

FIG. 5 is a view showing the pixel 101 and an equivalent circuit of the signal processing circuit 103 corresponding to the pixel 101 in FIGS. 2 and 3.

An APD 201 generates charge pairs in response to incident light by photoelectric conversion. One node of two nodes of the APD 201 is connected to a power line through which a drive voltage VL (first voltage) is supplied. In addition, the other node of two nodes of the APD 201 is connected to another power line through which a drive voltage VH (second voltage) higher than the voltage VL is supplied.

The one node of the APD 201 shown in FIG. 4 is an anode, and the other node of the APD is a cathode. A reverse bias voltage VR is supplied to the anode and the cathode of the APD 201 such that the APD 201 performs an avalanche multiplication operation. Specifically, the reverse bias voltage VR is supplied between the anode (one node) and the cathode (the other node) of the APD 201. Here, the reverse bias voltage VR is obtained by the following Expression (1). $VR = VL - VH$

In a state in which such a voltage is supplied, electric charge generated by incident light causes avalanche multiplication so that an avalanche current is generated.

When the reverse bias voltage is supplied, a Geiger mode operates with a voltage difference that is the voltage difference between the anode and the cathode greater than a breakdown voltage, and a linear mode operates with a voltage difference that is the voltage difference between the anode and the cathode near or equal to or smaller than the breakdown voltage. The APD which operates in the Geiger mode will be referred to as an SPAD. In the case of the SPAD, for example, the voltage VL (first voltage) is -30 V, and the voltage VH (second voltage) is 1 V.

A quench element 202 is connected to the power line to which the drive voltage VH is supplied and one node of the anode and the cathode of the APD 201. The quench element 202 functions as a load circuit (quench circuit) during signal multiplication by avalanche multiplication and serves to suppress the voltage supplied to the APD 201 and curb avalanche multiplication (quench operation). In addition, the quench element 202 serves to return the voltage supplied to the APD 201 to the drive voltage VH by causing a current to flow by the amount corresponding to the voltage drop in quench operation (recharge operation).

In FIG. 5, an example in which the signal processing circuit 103 has a waveform shaping unit 210, a counter circuit 211, and a selection circuit 212 in addition to the quench element 202 has been described. However, the signal processing circuit 103 need only have at least any one of the waveform shaping unit 210, the counter circuit 211, and the selection circuit 212 in addition to the quench element 202.

The waveform shaping unit 210 shapes voltage change of the cathode of the APD 201 obtained when photons are detected and outputs a pulse signal. An inverter circuit is used as the waveform shaping unit 210, for example. In FIG. 5, an example in which one inverter is used as the waveform shaping unit 210 has been described, but a circuit in which a plurality of inverters is connected in series may be used, or other circuits having an effect of shaping a waveform may be used.

The counter circuit 211 counts pulse signals output from the waveform shaping unit 210 and retains the counted values. In addition, when a control pulse RES is supplied through a drive wire 213, the signals retained in the counter circuit 211 are reset.

In the selection circuit 212, a control pulse SEL is supplied from the vertical scanning circuit 110 in FIG. 3 through a drive wire 214 in FIG. 5 (not shown in FIG. 3) for switching between electrical connection and non-connection of the counter circuit 211 and the signal line 113. The selection circuit 212 includes a buffer circuit or the like for outputting a signal, for example, and outputs an output signal from the counter circuit 211 of the pixel to the signal line 113.

Electrical connection may be switched by disposing a switch such as a transistor between the quench element 202 and the APD 201 or between the photoelectric conversion unit 102 and the signal processing circuit 103. Similarly, supply of the voltage VH or the voltage VL supplied to the photoelectric conversion unit 102 may be may electrically switched using a switch such as a transistor.

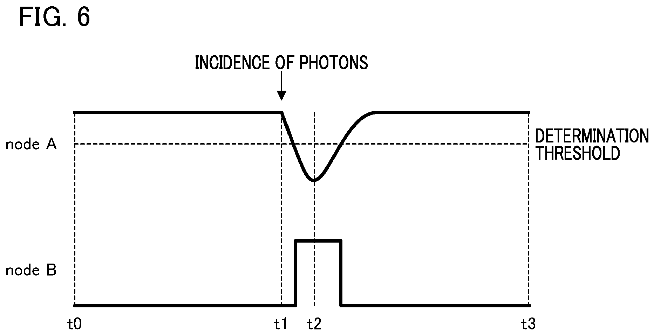

FIG. 6 is a view schematically showing a relationship between operation of the APD 201 of First Embodiment and an output signal. An input side of the waveform shaping unit 210 is a node A, and an output side is a node B. During a period from a time t0 to a time t1, a potential difference of VR (VL-VH) is applied to the APD 201. If photons are incident on the APD 201 at the time t1, avalanche multiplication occurs in the APD 201, an avalanche multiplication current flows in the quench element 202, and the voltage of the node A drops. If the amount of voltage drop further increases and the potential difference applied to the APD 201 is reduced, avalanche multiplication of the APD 201 stops as that at a time t2, and the voltage level of the node A no longer drops below a certain value. Thereafter, during a period from the time t2 to a time t3, a current which compensates for the amount corresponding to the voltage drop from the voltage VL flows in the node A, and the node A is statically determinate at an original potential level at the time t3. At this time, the part in which output waveform has exceeded a certain threshold in the node A is subjected to waveform shaping by the waveform shaping unit 210 and is output as a pulse signal in the node B. Hereinafter, a photoelectric conversion device 300 of Present Embodiment will be described in detail.

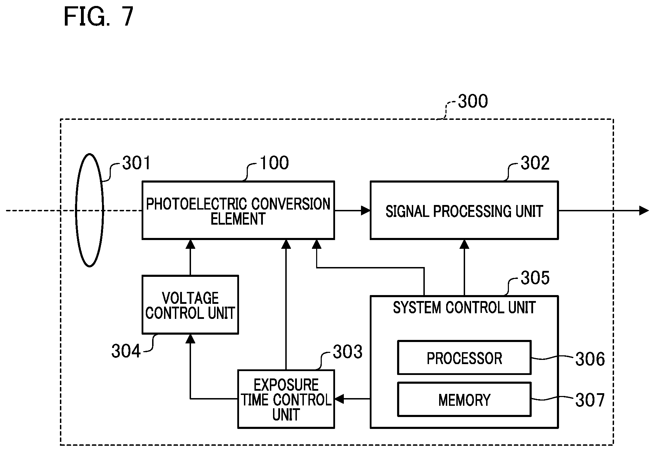

FIG. 7 is a functional block diagram of the photoelectric conversion device 300 according to First Embodiment. The photoelectric conversion device 300 of Present Embodiment is constituted to have the photoelectric conversion element 100, the image formation optical system 301, a signal processing unit 302, an exposure time control unit (second control unit) 303, a voltage control unit (first control unit) 304, and a system control unit 305. Since the photoelectric conversion element 100 is similar to the photoelectric conversion element 100 shown in FIGS. 1 to 6, description thereof will be omitted.

The image formation optical system (image capturing optical system) 301 has a variable magnification lens (zoom lens) which is a lens forming an optical image of a subject and moving in an optical axis direction during variable magnification, and a focus lens which moves in the optical axis direction during focus adjustment (focusing). In addition, the image formation optical system 301 may include an aperture and an ND for controlling the amount of incident light, and an IRCF for controlling the amount of incident light of infrared light.

The signal processing unit 302 generates an image through processing of a signal acquired by the photoelectric conversion element 100. The processing performed by the signal processing unit 302 (image processing) will be described below. An image generated by the signal processing unit 302 through image processing is output to the outside of the photoelectric conversion device 300 via a communication unit (not shown). The communication unit (not shown) has a function of receiving a signal from the outside, in addition to outputting the generated image.

The exposure time control unit (second control unit) 303 controls the exposure time by setting (determining) an exposure time for integrating the number of photons incident on the photoelectric conversion element 100.

The voltage control unit (first control unit) 304 controls a reverse bias current by applying a reverse bias voltage to the APD 201 of each of the pixels in the photoelectric conversion element 100. The voltage control unit 304 includes a control IC capable of controlling a reverse bias voltage and can be constituted to be able to control a reverse bias voltage by rewriting a register of the control IC. In addition, it may include a plurality of power sources and may be constituted to be able to select a power source from the plurality of power sources to be applied to the APD 201 of the photoelectric conversion element 100.

The system control unit 305 includes a processor 306, a memory 307 serving as a storage medium, a driver of each I/F, and the like, is constituted of at least one computer, and is connected to constituent elements respectively through lines of the photoelectric conversion device 300. In addition, some or all of the functional blocks shown in FIG. 7 are realized by causing the computer included in the photoelectric conversion device 300 to execute a computer program stored in the memory 307 serving as a storage medium.

Some or all of these may be realized by hardware. A dedicated circuit (ASIC), a processor (a reconfigurable processor, DSP), or the like can be used as hardware. In addition, each of the functional blocks shown in FIG. 7 may not be built into the same casing and may be constituted of separate devices connected to each other through signal lines.

The processor 306 is a central processing device constituted of one or a plurality of central processing units (CPUs), micro processing units (MPUs), or the like. The memory 307 is constituted to include a read only memory (ROM) or a random access memory (RAM). The ROM is a non-volatile memory and stores the computer program according to Present Embodiment and programs, data, and the like required for other control. The RAM is a volatile memory and stores image data and temporary data such as processing results according to Present Embodiment.

When the pixels are avalanche photodiodes (APDs), erroneous counting occurs in adjacent pixels, that is, crosstalk (which will hereinafter be referred to as luminous crosstalk) occurs between adjacent pixels due to an avalanche luminescence phenomenon.

An influence of photons incident on one pixel on adjacent pixels is determined by the probability of occurrence of luminous crosstalk. Further, it is known that the probability of occurrence of luminous crosstalk depends on the reverse bias voltage applied to the APD 201. Specifically, when the breakdown voltage of the APD 201 is VBD, the probability of occurrence of luminous crosstalk increases as the absolute value of an excess bias VEX determined by the following Expression (2) becomes larger. $\left|VEX\right| = \left|VR\right| - \left|VBD\right|$

Hence, in the photoelectric conversion device 300 of Present Embodiment, the reverse bias voltage applied to the APD 201 is controlled in accordance with the exposure time set by the exposure time control unit 303. Accordingly, deterioration in image quality due to erroneous counting can be curbed. Hereinafter, the reason why deterioration in image quality due to erroneous counting can be curbed by the voltage control unit 304 according to Present Embodiment controlling the reverse bias current will be described.

It is known that the absolute value of the breakdown voltage VBD in the foregoing Expression (2) increases as the temperature of the photoelectric conversion element 100 becomes higher. For this reason, it is preferable to control the reverse bias voltage applied by the voltage control unit 304 by not only the exposure time set by the exposure time control unit 303 but also the temperature of the photoelectric conversion element 100. Specifically, the photoelectric conversion device 300 has a temperature sensor acquiring the temperature of the photoelectric conversion element 100 and controls the reverse bias voltage applied by the voltage control unit 304 using the values acquired by the temperature sensor such that the absolute value of the excess bias VEX becomes constant regardless of the temperature. In this manner, it is preferable to control the reverse bias voltage applied by the voltage control unit 304 using the values acquired by the temperature sensor such that the absolute value of the excess bias VEX becomes constant regardless of the temperature.

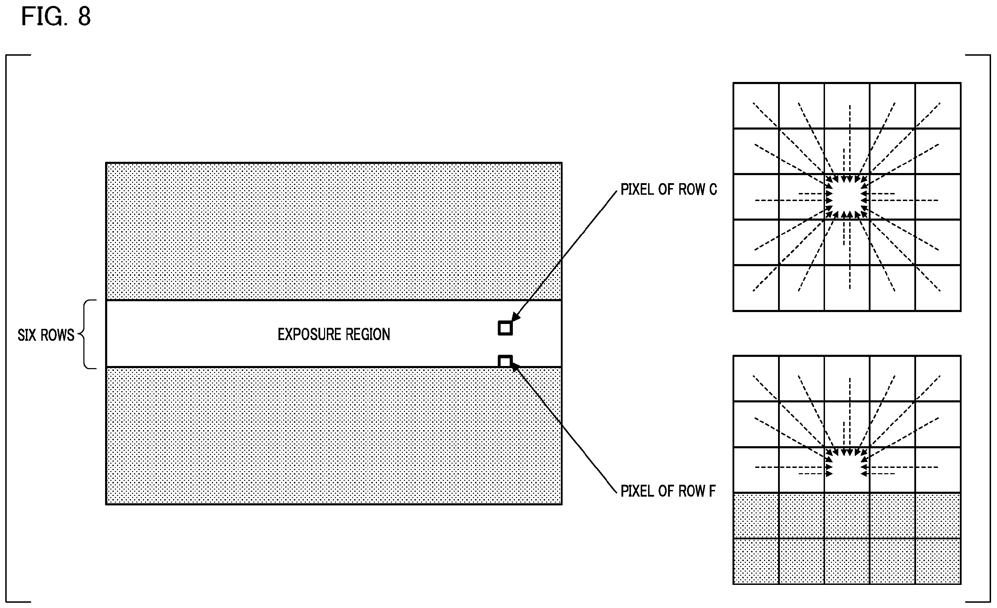

In the photoelectric conversion element 100 according to Present Embodiment, the vertical scanning circuit 110 simultaneously reads multiple rows as shown in FIG. 4, that is, simultaneously reads signals from the pixels included in a plurality of rows in the pixel region 12. For this reason, as shown in FIG. 8, the amount of luminous crosstalk received from the surrounding pixels differs depending on the positions within multiple rows to be simultaneously read. FIG. 8 is an explanatory view of luminous crosstalk when simultaneous multiple-row reading is performed. Specifically, the row F receives only the luminous crosstalk from the pixels in the upper half, but the row C receives the luminous crosstalk from the pixels on the upper, lower, left, and right sides.

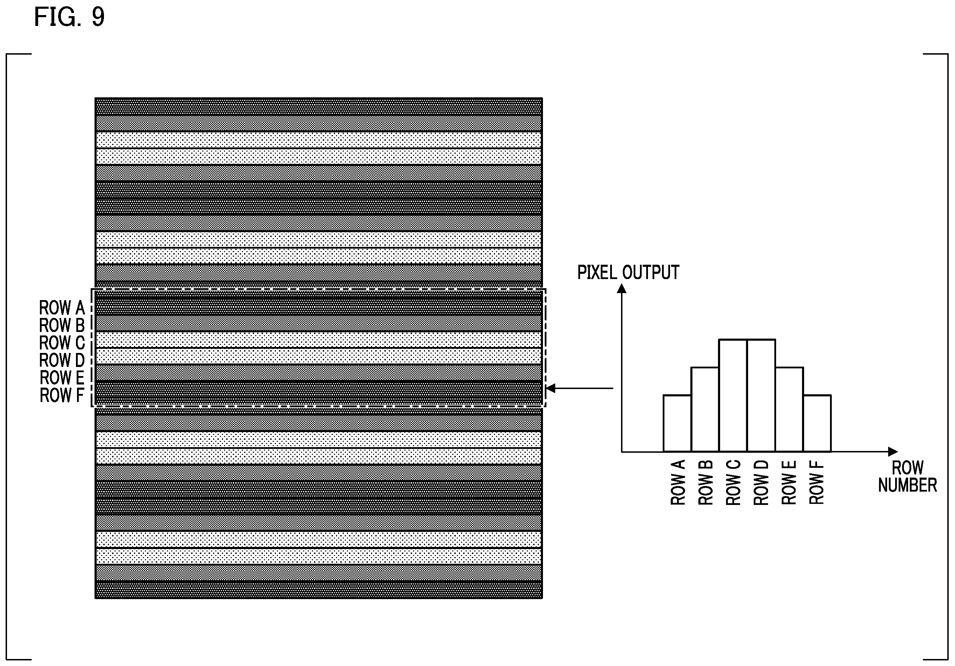

For this reason, when the brightness of a subject is uniform, as in FIG. 9, since the brightness of the row A and the row F becomes dark and the brightness of the row C and the row D becomes the brightest, horizontal streaks are generated in an image so that the quality of an image is degraded due to the influence of luminous crosstalk. FIG. 9 is an explanatory view of deterioration in image quality due to erroneous counting caused by luminous crosstalk.

The horizontal streaks described in FIGS. 8 and 9 are noticeable as the exposure time of the photoelectric conversion element 100 becomes shorter and are less noticeable as the exposure time becomes longer, which will be described below in detail. Hence, the voltage control unit 304 of the photoelectric conversion device 300 of Present Embodiment controls the reverse bias voltage such that the absolute value of the excess bias applied to the APD 201 is reduced as the exposure time set by the exposure time control unit 303 becomes shorter. In this manner, control of reducing the probability of occurrence of luminous crosstalk as the exposure time becomes shorter can be performed by controlling the reverse bias voltage applied to the APD 201. Due to such a constitution, in the photoelectric conversion device 300 according to Present Embodiment, deterioration in image quality due to erroneous counting caused by avalanche luminescence can be curbed.

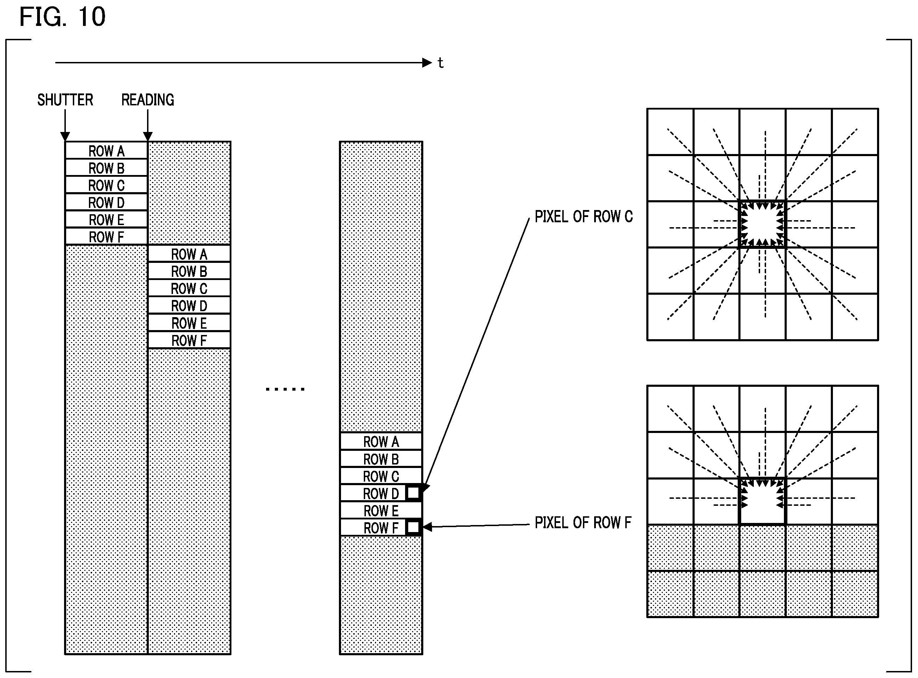

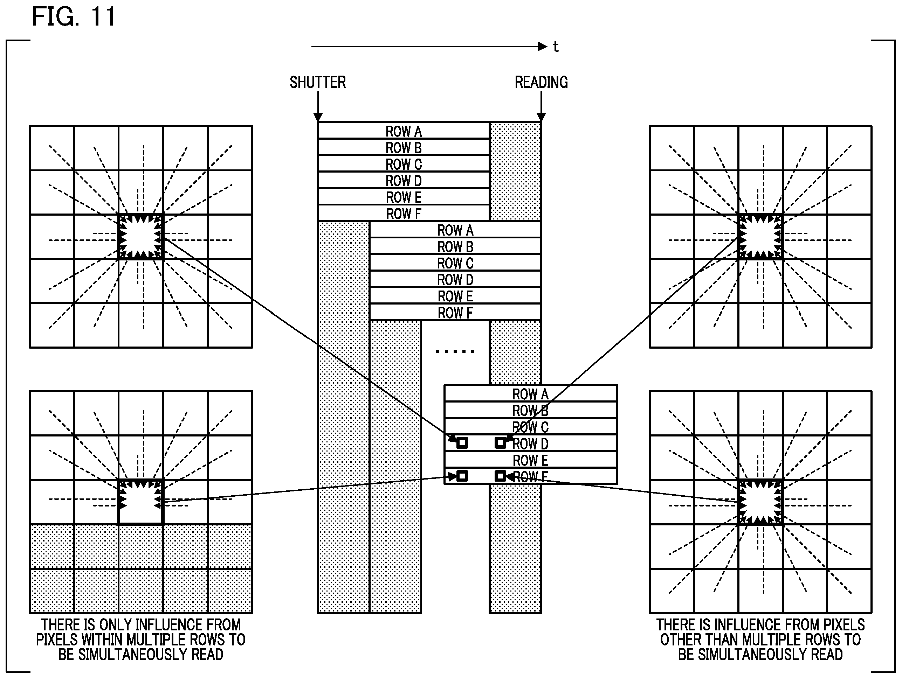

FIGS. 10 and 11 are views each showing a timing chart of the photoelectric conversion element 100 when the exposure time differs. FIG. 10 is a view showing a timing chart of the photoelectric conversion element 100 when the exposure time is short. FIG. 11 is a view showing a timing chart of the photoelectric conversion element 100 when the exposure time is long.

In FIG. 10, there are six rows to be subjected to simultaneous exposure operation at all timings during exposure operation. That is, since exposure operation is not performed in the pixels other than the multiple rows to be simultaneously read, only an influence of luminous crosstalk from the pixels within the multiple rows to be simultaneously read is received. On the other hand, in FIG. 11, during exposure operation, there is a period in which exposure operation is also performed in the pixels other than the multiple rows to be simultaneously read. During this period, an influence of luminous crosstalk from the pixels other than the multiple rows to be simultaneously read is also received. Further, as is evident from FIG. 11, the period of receiving an influence of luminous crosstalk from the pixels other than the multiple rows to be simultaneously read is lengthened as the exposure time becomes longer.

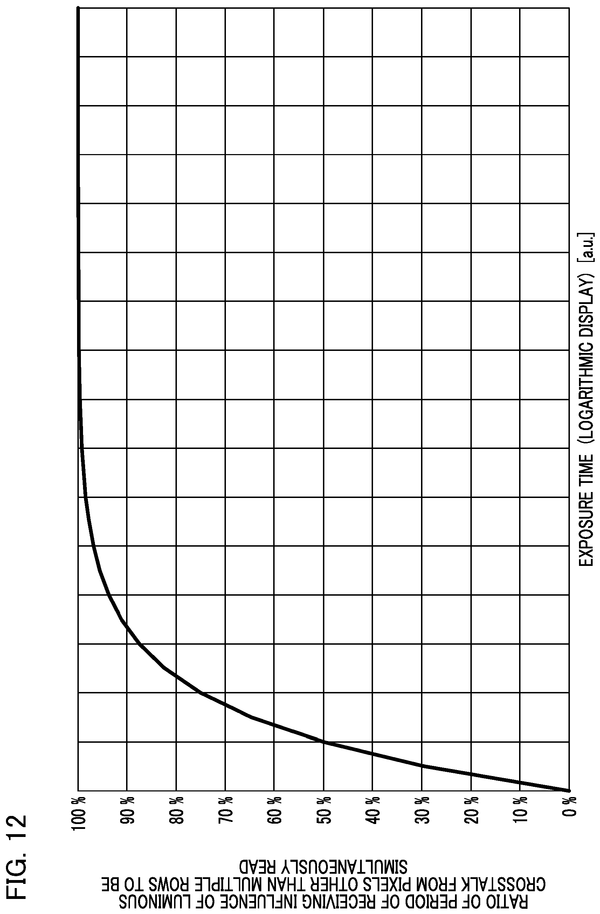

FIG. 12 is a view in which the horizontal axis indicates the exposure time and the vertical axis indicates the ratio of the period of receiving an influence of luminous crosstalk from the pixels other than the multiple rows to be simultaneously read. As is evident from FIG. 12, the ratio of the period of receiving an influence of luminous crosstalk from the pixels other than the multiple rows to be simultaneously read increases as the exposure time becomes longer, and if the exposure time becomes longer than a certain degree, the ratio scarcely changes.

Therefore, in the photoelectric conversion device 300 of Present Embodiment, the voltage control unit 304 controls the reverse bias voltage applied to the APD 201 such that the absolute value of the excess bias applied to the APD 201 is reduced as the exposure time set by the exposure time control unit 303 becomes shorter. Accordingly, deterioration in image quality due to erroneous counting caused by luminous crosstalk can be curbed.

As shown in FIG. 12, if the exposure time becomes longer to a certain degree, the ratio of the period of receiving an influence of luminous crosstalk from the pixels other than the multiple rows to be simultaneously read scarcely changes. Hence, it is preferable for the voltage control unit 304 to control the value of the reverse bias voltage applied to the APD 201 by setting a predetermined (particular) threshold in advance such that the absolute value of the excess bias applied to the APD 201 becomes constant when the exposure time is equal to or longer than the predetermined threshold. Here, when the voltage control unit 304 controls the value of the excess bias, not only the luminous crosstalk but also the sensitivity of the APD 201 and the like change. For this reason, when the exposure time is equal to or longer than a predetermined threshold and deterioration in image quality due to horizontal streaks caused by luminous crosstalk can be disregarded, it is preferable to control the value of the excess bias by putting emphasis on other conditions such as the sensitivity.

In addition, the signal processing unit 302 according to Present Embodiment can perform processing of applying a digital gain to a signal acquired by the photoelectric conversion element 100, that is, a signal read by the vertical scanning circuit 110. Further, the signal processing unit 302 may adjust the brightness of an image by applying a digital gain to a signal acquired by the photoelectric conversion element 100. Horizontal streaks caused by luminous crosstalk due to an influence of random noise is less likely to be seen as the digital gain becomes higher. For this reason, it is preferable that the voltage control unit 304 control the reverse bias voltage applied to the APD 201 such that the absolute value of the excess bias applied to the APD 201 is reduced as a digital gain applied by the signal processing unit 302.

In addition, the signal processing unit 302 according to Present Embodiment can perform processing of generating an image from a signal acquired by the photoelectric conversion element 100, that is, a signal read by the vertical scanning circuit 110. Further, when a captured image is generated using a signal acquired by the photoelectric conversion element 100, the signal processing unit 302 can execute image processing such as black level correction, gamma curve adjustment, noise reduction, edge enhancement, and data compression. The signal processing unit 302 may generate a captured image by performing each process of the processing. Since the visibility of horizontal streaks caused by luminous crosstalk varies depending on parameters of image processing, it is preferable that the voltage control unit 304 control the reverse bias voltage applied to the APD 201 depending on parameters of the presence or absence of image processing.

For example, since random noise is reduced when noise reduction (the foregoing image processing) is strongly applied, horizontal streaks caused by luminous crosstalk may become noticeable. Therefore, it is preferable that the voltage control unit 304 control the reverse bias voltage applied to the APD 201 such that the absolute value of the excess bias applied to the APD 201 is reduced as the signal processing unit 302 applies stronger noise reduction.

In addition, if edge enhancement (the foregoing image processing) is strengthened or a gamma curve for emphasizing the contrast of horizontal streaks is applied, horizontal streaks may become noticeable. For this reason, when the signal processing unit 302 strengthens edge enhancement or applies a gamma curve for emphasizing the contrast of horizontal streaks, it is preferable to control the reverse bias voltage such that the absolute value of the excess bias applied to the APD 201 is reduced. Similarly, control of the reverse bias voltage is performed by the voltage control unit 304.

In addition, the visibility of horizontal streaks caused by luminous crosstalk also varies depending on a subject. Specifically, horizontal streaks become more noticeable in a subject having no texture or a subject having fewer spatial frequency components. For this reason, it is preferable that the voltage control unit 304 control the reverse bias voltage applied to the APD 201 depending on a subject to be image-captured.

In addition, the photoelectric conversion element 100 of Present Embodiment may include an on-chip color filter to serve as a photoelectric conversion element capable of acquiring color information. For example, when a photoelectric conversion element with an RGGB Bayer layout is used, an influence of luminous crosstalk is more likely to appear as the colors are biased. The reason therefor will be described below.

For example, when an image of a green subject is captured, the number of photons incident on a G pixel is larger than the number of photons incident on an R pixel or a B pixel. Since an avalanche luminescence phenomenon occurs more often as the number of times of avalanche amplification increases, when the number of photons incident on the G pixel is larger than that on the R pixel or the B pixel, the avalanche luminescence phenomenon occurs more often in the G pixel than in the R pixel or the B pixel. Therefore, when an image of a green subject is captured, erroneous counting occurs often in the R pixel or the B pixel due to avalanche luminescence which has occurred in the G pixel. That is, horizontal streaks become more noticeable when an image of a predetermined color-biased image of a subject is captured. For this reason, it is preferable that the voltage control unit 304 control the reverse bias voltage applied to the APD 201 such that the absolute value of the excess bias applied to the APD 201 is reduced when an image of a predetermined color-biased image of a subject is captured.

Moreover, the photoelectric conversion device 300 of Present Embodiment can be constituted to be able to control the reverse bias voltage applied to the APD 201 by the voltage control unit 304 for each color channel, and it is preferable to have this constitution. That is, the voltage control unit 304 controls the reverse bias voltage applied to the APD 201 such that the absolute value of the excess bias applied to the APD of the color channel with the relatively larger number of photons incident on the pixel becomes smaller than that of the color channel with the relatively smaller number of photons incident on the pixel. This is preferable because an influence of horizontal streaks caused by luminous crosstalk can be reduced in this manner.

It is preferable that a timing at which the voltage control unit 304 controls the reverse bias voltage applied to the APD 201 be a timing not overlapping the exposure time of each pixel of the photoelectric conversion element 100, that is a so-called blank period. The reason therefor will be described below.

As described above, when the value of the excess bias applied to the APD 201 is controlled by the voltage control unit 304, the sensitivity of the APD 201 also varies. For this reason, if the reverse bias voltage applied to the APD 201 is controlled by the voltage control unit 304 at a timing overlapping the exposure time of each pixel of the photoelectric conversion element 100, a luminance level difference occurs in the middle of a captured image. Therefore, in order to curb occurrence of a luminance level difference, it is preferable that the timing at which the voltage control unit 304 controls the reverse bias voltage applied to the APD 201 be during the blank period.

Hereinabove, in order to curb deterioration in image quality due to horizontal streaks generated due to luminous crosstalk, the reverse bias voltage applied to the APD 201 has been controlled by the voltage control unit 304, but a method other than controlling the reverse bias voltage applied to the APD 201 may be combined. For example, in accordance with the exposure time set by the exposure time control unit 303, the parameters in image processing may be changed. That is, the digital gain or the parameters of noise reduction is changed in accordance with the set exposure time. With FIG. 9 as an example, since the positions where the rows which become relatively brighter and dark are determined in the multiple rows to be simultaneously read in the example shown in FIG. 9, a negative digital gain may be applied to the rows which become brighter or a positive digital gain may be applied to the rows which become dark. In addition, processing of a low pass filter may be applied in the vertical direction such that horizontal streaks become less noticeable.

### <Second Embodiment>

When the value of the excess bias is controlled by the voltage control unit 304, not only luminous crosstalk but also the sensitivity of the APD 201 varies. For this reason, when the absolute value of the reverse bias voltage applied to the APD 201 is reduced as the exposure time set by the exposure time control unit 303 becomes shorter, deterioration in image quality due to horizontal streaks can be curbed. On the other hand, response characteristics with respect to the exposure time, so-called shutter linearity, may deviate.

Hence, in Second Embodiment, the photoelectric conversion device 300 capable of curbing degradation in shutter linearity occurring when the absolute value of the reverse bias voltage applied to the APD 201 is reduced as the integration time set by the exposure time control unit 303 becomes shorter will be described. Since the constitution, the circuit board, and each of the functional units of the photoelectric conversion device 300 of Second Embodiment are similar to those in First Embodiment, description thereof will be omitted.

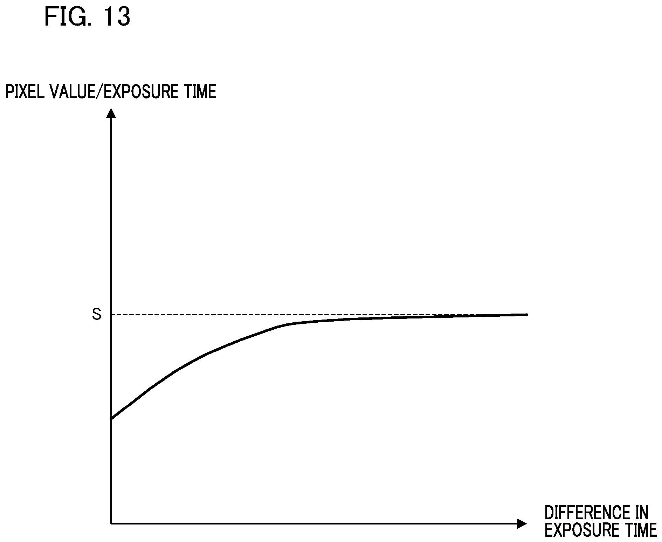

FIG. 13 is an explanatory view of shutter linearity of the photoelectric conversion element 100 of Second Embodiment. Specifically, it is a view showing characteristics when the horizontal axis indicates the exposure time and the vertical axis indicates the result of magnitude of signal output from photoelectric conversion element (pixel value) ÷ exposure time. The dotted line shown in FIG. 13 indicates a case in which a constant reverse bias voltage is applied regardless of the exposure time. In addition, the solid line shown in FIG. 13 indicates a case in which the voltage control unit 304 controls the reverse bias voltage such that the absolute value of the excess bias VEX applied to the APD 201 is reduced as the exposure time becomes shorter. Since the sensitivity of the APD 201 increases as the absolute value of the excess bias VEX becomes larger, the characteristics indicated by the solid line deviate particularly on a side where the exposure time is short compared to the dotted line indicating the characteristics of ideal shutter linearity.

For this reason, in the photoelectric conversion device 300 of Present Embodiment, degradation in sensitivity occurring when the exposure time is short is compensated for by lengthening the exposure time of the photoelectric conversion element 100 or applying a digital gain. That is, the voltage control unit 304 reduces an EV value applied to the photoelectric conversion device 300 compared to the EV value of a set exposure target as the absolute value of the excess bias applied to the APD 201 becomes smaller. Accordingly, in Second Embodiment, similarly to First Embodiment, it is possible to provide a photoelectric conversion device curbing deterioration in image quality due to erroneous counting caused by avalanche luminescence.

When a digital gain is applied, the signal processing unit 302 increases the digital gain applied to the signal value as the exposure time becomes shorter. Accordingly, deterioration in image quality due to erroneous counting caused by avalanche luminescence can be curbed, and deviation of shutter linearity can also be curbed.

Here, when the signal processing unit 302 increases the digital gain applied to the signal value as the exposure time becomes shorter, the SN ratio of an image is degraded because random noise components are amplified due to the digital gain. For this reason, the signal processing unit 302 increases the digital gain applied to the signal value as the exposure time becomes shorter and strengthens noise reduction. In this manner, it is more preferable that the signal processing unit 302 change the parameters of image processing in accordance with the exposure time, that is, as the exposure time becomes shorter.

As described above, when the exposure time is equal to or longer than a predetermined threshold, it is preferable that the voltage control unit 304 control the value of the reverse bias voltage applied to the APD 201 as the absolute value of the excess bias applied to the APD 201 becomes constant. At this time, when the exposure time is equal to or longer than a predetermined threshold, the signal processing unit 302 also maintains the gain applied to the signal value constant. In such a case, it is preferable to maintain the gain applied to the signal value constant. At this time, the threshold is set in advance.

Next, a case in which degradation in sensitivity is compensated for based on the exposure time of the photoelectric conversion element 100 will be described. An exposure time set as an exposure target for capturing an image of a subject with appropriate brightness is regarded as T0. When the sensitivity while the exposure time is sufficiently long is S, the sensitivity is degraded to S0 due to the reverse bias voltage applied to the APD 201 when the exposure time is short. Hence, the exposure time T actually set in the photoelectric conversion element 100 is obtained by the following Expression (3). $T = T 0 \times \left(S/S0\right)$

That is, the exposure time control unit 303 sets a longer exposure time in the photoelectric conversion element 100 than the exposure time determined from the exposure target as the exposure time becomes shorter. Accordingly, deterioration in image quality due to erroneous counting caused by avalanche luminescence can be curbed, and deviation of shutter linearity can also be curbed.

As described above, when the exposure time is equal to or longer than a predetermined threshold, it is preferable that the voltage control unit 304 control the value of the reverse bias voltage applied to the APD 201 as the absolute value of the excess bias applied to the APD 201 becomes constant. At this time, when the exposure time is equal to or longer than a predetermined threshold, the exposure time control unit 303 makes the exposure time determined from the exposure target and the exposure time set in the photoelectric conversion element equivalent to each other. In such a case, it is preferable to make the exposure time determined from the exposure target and the exposure time set in the photoelectric conversion element equivalent to each other. At this time, the threshold is set in advance.

Degradation in sensitivity occurring when the exposure time is short may be compensated for by a digital gain or may be compensated for by lengthening the exposure time, or both may be combined. However, it is preferable to compensate for it by lengthening the exposure time. The reason therefor will be described below.

As described in FIGS. 10 and 11, horizontal streaks generated due to luminous crosstalk become more noticeable as the exposure time becomes longer. Therefore, deterioration in image quality due to horizontal streaks can be further curbed by setting a longer exposure time in the photoelectric conversion element 100 than the exposure time determined from the exposure target.

For the foregoing reason, it is preferable to compensate for degradation in sensitivity occurring when the exposure time is short by lengthening the exposure time because deterioration in image quality due to horizontal streaks can be further curbed.

### <Third Embodiment>

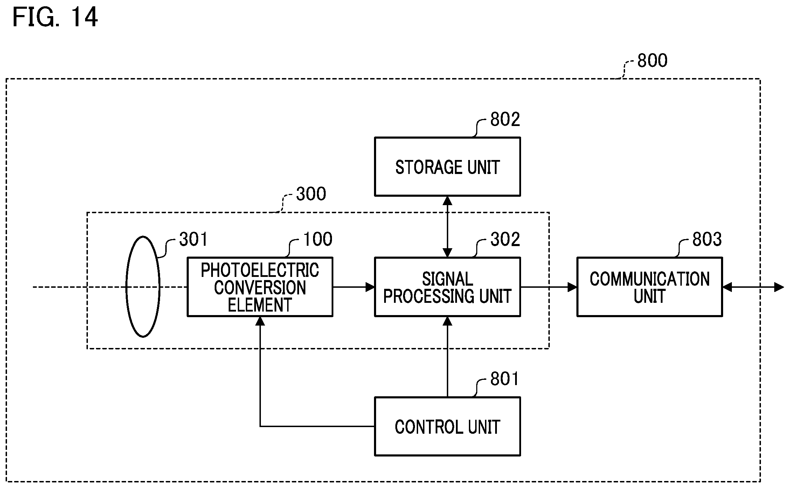

FIG. 14 is a system block diagram showing a photoelectric conversion system using the photoelectric conversion device 300 of First to Third Embodiments. A photoelectric conversion system 800 according to Third Embodiment includes the photoelectric conversion device 300 having the image formation optical system 301 and the photoelectric conversion element 100, a control unit 801, a storage unit 802, and a communication unit 803. Since the constitution, the circuit board, and each of the functional units of the photoelectric conversion device 300 included in the photoelectric conversion system of Third Embodiment described below are similar to those in First Embodiment, detailed description thereof will be suitably omitted.

The image formation optical system (image capturing optical system) 301 is a lens for forming an optical image of a subject. In the photoelectric conversion element 100, an optical image formed by the image formation optical system 301 is captured. A signal read from the photoelectric conversion element 100 is subjected to processing such as black level correction, gamma curve adjustment, noise reduction, and data compression (image processing) in addition to image generation and correction processing in the signal processing unit 302, and a final image is generated. When the photoelectric conversion element 100 has an RGB on-chip color filter, it is more preferable to perform processing such as white balance correction or color conversion.

The control unit 801 includes a processor (not shown), a memory serving as a storage medium, a driver of each I/F, and the like, is constituted of at least one computer, and is connected to the constituent elements respectively through lines of the photoelectric conversion device 300. The control unit 801 functions as a control means for controlling operation of each unit of the photoelectric conversion system 800 in its entirety based on the computer program stored in the memory serving as a storage medium. In addition, some or all of the functional blocks shown in FIG. 14 are realized by causing the computer to execute a computer program stored in the memory serving as a storage medium.

Some or all of these may be realized by hardware. A dedicated circuit (ASIC), a processor (a reconfigurable processor, DSP), or the like can be used as hardware. In addition, each of the functional blocks shown in FIG. 7 may not be built into the same casing and may be constituted of separate devices connected to each other through signal lines.

The processor (not shown) is a central processing device constituted of one or a plurality of CPUs, MPUs, or the like. In addition, the memory (not shown) is constituted to include a ROM or a RAM. The ROM is a non-volatile memory and stores the computer program according to Present Embodiment and programs, data, and the like required for other control. The RAM is a volatile memory and stores image data and temporary data such as processing results according to Present Embodiment.

The control unit 801 can execute each process of the processing performed by the exposure time control unit 303 and the voltage control unit 304 according to First and Second Embodiments. That is, in Third Embodiment, each process of the processing performed by the exposure time control unit 303 and the voltage control unit 304 is performed by the control unit 801. For this reason, in Third Embodiment, the system control unit 305 described in First Embodiment is not necessary. In addition, the control unit 801 performs control and the like of the length of the exposure period of each frame of the photoelectric conversion element 100 and the timing of a control signal CLK through the control pulse generation unit 115 of the photoelectric conversion element 100.

The storage unit 802 is a recording medium such as a memory card or a hard disk for storing electronic data and programs, for example. An external storage device may be used as that playing a similar role. Here, for example, the external storage device can be realized by media (recording media) and an external storage drive for realizing access to the media. For example, a flexible disk (FD), a CD-ROM, a DVD, a USB memory, a MO, and a flash memory are known as such media. In addition, an external storage device may be a server device or the like connected through a network. The communication unit 803 includes a wireless or wired interface and it outputs generated images to the outside of the photoelectric conversion system 800 and receives signals from the outside.

Hereinabove, in the photoelectric conversion system according to Third Embodiment, similarly to First Embodiment, deterioration in image quality due to erroneous counting caused by avalanche luminescence can be curbed.

While the present invention has been described with reference to exemplary embodiments, it is to be understood that the invention is not limited to the disclosed exemplary embodiments but by the scope of the following claims.

In addition, as a part or the whole of the control according to the embodiments, a computer program realizing the function of the embodiments described above may be supplied to the photoelectric conversion device and the like through a network or various storage media. Then, a computer (or a CPU, an MPU, or the like) of the photoelectric conversion device and the like may be configured to read and execute the program. In such a case, the program and the storage medium storing the program configure the present invention.

In addition, the present invention includes those realized using at least one processor or circuit configured to function of the embodiments explained above, for example. Dispersion processing may be performed using a plurality of processors.

## Claims

1. A photoelectric conversion device (300) comprising:
a photoelectric conversion element (100) having pixels constituted of avalanche photodiodes (201);
a first control unit (304) configured to control a reverse bias voltage applied to the avalanche photodiodes; and
a second control unit (303) configured to set an exposure time of the photoelectric conversion element,
wherein the first control unit controls the reverse bias voltage in accordance with an exposure time set by the second control unit,
wherein the first control unit controls the reverse bias voltage such that an absolute value of an excess bias applied to the avalanche photodiodes is reduced as the exposure time becomes shorter.

2. The photoelectric conversion device according to claim 1,
wherein the first control unit applies a reverse bias voltage between anodes and cathodes of the avalanche photodiodes.

3. The photoelectric conversion device according to any one of claims 1 to 2,
wherein the first control unit controls the reverse bias voltage such that an absolute value of an excess bias applied to the avalanche photodiodes becomes constant when the exposure time is equal to or longer than a predetermined threshold.

4. The photoelectric conversion device according to any one of claims 1 to 3 further comprising:
a signal processing unit configured to apply a digital gain to a signal output from the photoelectric conversion element,
wherein the first control unit controls the reverse bias voltage such that an absolute value of an excess bias applied to the avalanche photodiodes is reduced as the digital gain applied by the signal processing unit becomes lower.

5. The photoelectric conversion device according to any one of claims 1 to 4 further comprising:
a signal processing unit configured to perform image processing with respect to a signal output from the photoelectric conversion element and generate an image,
wherein the first control unit controls the reverse bias voltage based on a parameter of the image processing.

6. The photoelectric conversion device according to claim 5,
wherein the image processing includes noise reduction, and
wherein the first control unit controls the reverse bias voltage such that an absolute value of an excess bias applied to the avalanche photodiodes is reduced as the noise reduction applied by the signal processing unit becomes stronger.

7. The photoelectric conversion device according to claim 5 or 6,
wherein the image processing includes edge enhancement, and
wherein the first control unit controls the reverse bias voltage such that an absolute value of an excess bias applied to the avalanche photodiodes is reduced as the edge enhancement applied by the signal processing unit becomes stronger.

8. The photoelectric conversion device according to any one of claims 5 to 7,
wherein the image processing includes gamma curve adjustment, and
wherein the first control unit controls the reverse bias voltage based on a gamma curve.

9. The photoelectric conversion device according to any one of claims 1 to 8,
wherein the first control unit controls the reverse bias voltage at a timing not overlapping an exposure time of each pixel of the photoelectric conversion element.

10. The photoelectric conversion device according to any one of claims 1 to 9 further comprising:
a signal processing unit configured to perform image processing with respect to a signal output from the photoelectric conversion element and generate an image,
wherein the signal processing unit changes a parameter of the image processing in accordance with an exposure time set by the second control unit.

11. The photoelectric conversion device according to any one of claims 1 to 10 further comprising:
a temperature sensor configured to acquire a temperature of the photoelectric conversion element,
wherein the first control unit controls the reverse bias voltage such that an absolute value of an excess bias applied to the avalanche photodiodes becomes constant based on a temperature acquired by the temperature sensor.

12. A control method for a photoelectric conversion device according to any of claims 1 to 11 comprising:
setting an exposure time of a photoelectric conversion element having pixels including avalanche photodiodes; and
controlling a reverse bias voltage applied to the avalanche photodiodes in accordance with the set exposure time such that an absolute value of an excess bias applied to the avalanche photodiodes is reduced as the exposure time becomes shorter.

13. A non-transitory computer-readable storage medium configured to store a computer program for a photoelectric conversion device to execute the method of claim 12.

14. A computer program for a photoelectric conversion device to execute the method of claim 12.

## Patentansprüche

1. Fotoelektrische Umwandlungseinrichtung (300), die aufweist:
ein fotoelektrisches Umwandlungselement (100), das Pixel, die aus Lawinenfotodioden (201) gebildet sind, aufweist;
eine erste Steuereinheit (304), die konfiguriert ist, eine umgekehrte Vorspannung, die an die Lawinenfotodioden angelegt ist, zu steuern; und
eine zweite Steuereinheit (303), die konfiguriert ist, eine Belichtungszeit des fotoelektrischen Umwandlungselements einzustellen,
wobei die erste Steuereinheit die umgekehrte Vorspannung gemäß einer Belichtungszeit, die durch die zweite Steuereinheit eingestellt ist, steuert,
wobei die erste Steuereinheit die umgekehrte Vorspannung so steuert, dass ein absoluter Wert einer Überschussvorspannung, die an die Lawinenfotodioden angelegt ist, reduziert wird, wenn die Belichtungszeit kürzer wird.

2. Fotoelektrische Umwandlungseinrichtung nach Anspruch 1,
wobei die erste Steuereinheit eine umgekehrte Vorspannung zwischen Anoden und Katoden der Lawinenfotodioden anlegt.

3. Fotoelektrische Umwandlungseinrichtung nach einem der Ansprüche 1 bis 2,
wobei die erste Steuereinheit die umgekehrte Vorspannung so steuert, dass ein absoluter Wert einer Überschussvorspannung, die an die Lawinenfotodioden angelegt wird, konstant wird, wenn die Belichtungszeit gleich oder länger als ein vorbestimmter Schwellenwert wird.

4. Fotoelektrische Umwandlungseinrichtung nach einem der Ansprüche 1 bis 3, die ferner aufweist:
eine Signalverarbeitungseinheit, die konfiguriert ist, eine digitale Verstärkung auf ein Signal, das von dem fotoelektrischen Umwandlungselement ausgegeben wird, anzuwenden,
wobei die erste Steuereinheit die umgekehrte Vorspannung so steuert, dass ein absoluter Wert einer Überschussvorspannung, die an die Lawinenfotodioden angelegt wird, reduziert wird, wenn die digitale Verstärkung, die durch die Signalverarbeitungseinheit angelegt wird, kleiner wird.

5. Fotoelektrische Umwandlungseinrichtung nach einem der Ansprüche 1 bis 4, die ferner aufweist:
eine Signalverarbeitungseinheit, die konfiguriert ist, ein Bildverarbeiten mit Bezug auf ein Signal, das von dem fotoelektrischen Umwandlungselement ausgegeben wird, durchzuführen und ein Bild zu erzeugen,
wobei die erste Steuereinheit die umgekehrte Vorspannung basierend auf einem Parameter des Bildverarbeitens steuert.

6. Fotoelektrische Umwandlungseinrichtung nach Anspruch 5,
wobei die Bildverarbeitung eine Rauschreduzierung enthält, und
wobei die erste Steuereinheit die umgekehrte Vorspannung so steuert, dass ein absoluter Wert einer Überschussvorspannung, die an die Lawinenfotodioden angelegt ist, reduziert wird, wenn die Rauschreduzierung, die durch die Signalverarbeitungseinheit angewendet wird, stärker wird.

7. Fotoelektrische Umwandlungseinrichtung nach Anspruch 5 oder 6,
wobei das Bildverarbeiten eine Kantenverstärkung enthält, und
wobei die erste Steuereinheit die umgekehrte Vorspannung so steuert, dass ein absoluter Wert einer Überschussvorspannung, die an die Lawinenfotodioden angelegt wird, reduziert wird, wenn die Kantenverstärkung, die durch die Signalverarbeitungseinheit angewendet wird, stärker wird.

8. Fotoelektrische Umwandlungseinrichtung nach einem der Ansprüche 5 bis 7,
wobei das Bildverarbeiten eine Gammakurvenanpassung enthält, und
wobei die erste Steuereinheit die umgekehrte Vorspannung basierend auf einer Gammakurve steuert.

9. Fotoelektrische Umwandlungseinrichtung nach einem der Ansprüche 1 bis 8,
wobei die erste Steuereinheit die umgekehrte Vorspannung zu einer Zeit, die nicht mit einer Belichtungszeit von jedem Pixel des fotoelektrischen Umwandlungselements überlappt, steuert.

10. Fotoelektrische Umwandlungseinrichtung nach einem der Ansprüche 1 bis 9, die ferner aufweist:
eine Signalverarbeitungseinheit, die konfiguriert ist, ein Bildverarbeiten mit Bezug auf ein Signal, das von dem fotoelektrischen Umwandlungselement ausgegeben wird, durchzuführen und ein Bild zu erzeugen,
wobei die Signalverarbeitungseinheit einen Parameter des Bildverarbeitens gemäß einer Belichtungszeit, die durch die zweite Steuereinheit eingestellt wird, ändert.

11. Fotoelektrische Umwandlungseinrichtung nach einem der Ansprüche 1 bis 10, die ferner aufweist:
einen Temperatursensor, der konfiguriert ist, eine Temperatur des fotoelektrischen Umwandlungselements zu erlangen,
wobei die erste Steuereinheit die umgekehrte Vorspannung so steuert, dass ein absoluter Wert einer Überschussvorspannung, die an die Lawinenfotodioden angelegt wird, basierend auf einer Temperatur, die durch den Temperatursensor erlangt wird, konstant wird.

12. Steuerverfahren für eine fotoelektrische Umwandlungseinrichtung nach einem der Ansprüche 1 bis 11, das aufweist:
Einstellen einer Belichtungszeit eines fotoelektrischen Umwandlungselements, das Pixel, die Lawinenfotodioden enthalten, aufweist; und
Steuern einer umgekehrten Vorspannung, die an die Lawinenfotodioden angelegt wird, gemäß der eingestellten Belichtungszeit, sodass ein absoluter Wert einer Überschussvorspannung, die an die Lawinenfotodioden angelegt wird, reduziert wird, wenn die Belichtungszeit kürzer wird.

13. Nicht flüchtiges computerlesbares Speichermedium, das konfiguriert ist, ein Computerprogramm für eine fotoelektrische Umwandlungseinrichtung zu speichern, um das Verfahren nach Anspruch 12 auszuführen.

14. Computerprogramm für eine fotoelektrische Umwandlungseinrichtung, um das Verfahren nach Anspruch 12 auszuführen.

## Revendications

1. Dispositif de conversion photoélectrique (300) comprenant :
un élément de conversion photoélectrique (100) présentant des pixels constitués de photodiodes à avalanche (201) ;
une première unité de commande (304) configurée pour commander une tension de polarisation inverse appliquée aux photodiodes à avalanche ; et
une seconde unité de commande (303) configurée pour régler un temps d'exposition de l'élément de conversion photoélectrique,
dans lequel la première unité de commande commande la tension de polarisation inverse conformément à un temps d'exposition défini par la seconde unité de commande,
dans lequel la première unité de commande commande la tension de polarisation inverse de sorte qu'une valeur absolue d'une polarisation excessive appliquée aux photodiodes à avalanche soit réduite à mesure que le temps d'exposition diminue.

2. Dispositif de conversion photoélectrique selon la revendication 1,
dans lequel la première unité de commande applique une tension de polarisation inverse entre les anodes et les cathodes des photodiodes à avalanche.

3. Dispositif de conversion photoélectrique selon l'une quelconque des revendications 1 à 2,
dans lequel la première unité de commande commande la tension de polarisation inverse de sorte qu'une valeur absolue d'une polarisation excessive appliquée aux photodiodes à avalanche devienne constante lorsque le temps d'exposition est supérieur ou égal à un seuil prédéterminé.

4. Dispositif de conversion photoélectrique selon l'une quelconque des revendications 1 à 3, comprenant en outre :
une unité de traitement de signal configurée pour appliquer un gain numérique à un signal émis par l'élément de conversion photoélectrique,
dans lequel la première unité de commande commande la tension de polarisation inverse de sorte qu'une valeur absolue d'une polarisation excessive appliquée aux photodiodes à avalanche soit réduite à mesure que le gain numérique appliqué par l'unité de traitement de signal diminue.

5. Dispositif de conversion photoélectrique selon l'une quelconque des revendications 1 à 4, comprenant en outre :
une unité de traitement de signal configurée pour réaliser un traitement d'image par rapport à un signal émis par l'élément de conversion photoélectrique et générer une image,
dans lequel la première unité de commande commande la tension de polarisation inverse sur la base d'un paramètre du traitement d'image.

6. Dispositif de conversion photoélectrique selon la revendication 5,
dans lequel le traitement d'image inclut une réduction de bruit, et
dans lequel la première unité de commande commande la tension de polarisation inverse de sorte qu'une valeur absolue d'une polarisation excessive appliquée aux photodiodes à avalanche soit réduite à mesure que la réduction de bruit appliquée par l'unité de traitement de signal augmente.

7. Dispositif de conversion photoélectrique selon la revendication 5 ou 6,
dans lequel le traitement d'image inclut une amélioration de contour, et
dans lequel la première unité de commande commande la tension de polarisation inverse de sorte qu'une valeur absolue d'une polarisation excessive appliquée aux photodiodes à avalanche soit réduite à mesure que l'amélioration de contour appliquée par l'unité de traitement de signal augmente.

8. Dispositif de conversion photoélectrique selon l'une quelconque des revendications 5 à 7,
dans lequel le traitement d'image inclut un ajustement de courbe gamma, et
dans lequel la première unité de commande commande la tension de polarisation inverse sur la base d'une courbe gamma.

9. Dispositif de conversion photoélectrique selon l'une quelconque des revendications 1 à 8,
dans lequel la première unité de commande commande la tension de polarisation inverse à un moment ne chevauchant pas un temps d'exposition de chaque pixel de l'élément de conversion photoélectrique.

10. Dispositif de conversion photoélectrique selon l'une quelconque des revendications 1 à 9, comprenant en outre :
une unité de traitement de signal configurée pour réaliser un traitement d'image par rapport à un signal émis par l'élément de conversion photoélectrique et générer une image,
dans lequel l'unité de traitement de signal modifie un paramètre du traitement d'image conformément à un temps d'exposition défini par la seconde unité de commande.

11. Dispositif de conversion photoélectrique selon l'une quelconque des revendications 1 à 10, comprenant en outre :
un capteur de température configuré pour acquérir une température de l'élément de conversion photoélectrique,
dans lequel la première unité de commande commande la tension de polarisation inverse de sorte qu'une valeur absolue d'une polarisation excessive appliquée aux photodiodes à avalanche devienne constante sur la base d'une température acquise par le capteur de température.

12. Procédé de commande d'un dispositif de conversion photoélectrique selon l'une quelconque des revendications 1 à 11, comprenant :
le réglage d'un temps d'exposition d'un élément de conversion photoélectrique présentant des pixels incluant des photodiodes à avalanche ; et
la commande d'une tension de polarisation inverse appliquée aux photodiodes à avalanche conformément au temps d'exposition réglé de sorte qu'une valeur absolue d'une polarisation excessive appliquée aux photodiodes à avalanche soit réduite à mesure que le temps d'exposition diminue.

13. Support de stockage non transitoire lisible par ordinateur configuré pour stocker un programme informatique pour qu'un dispositif de conversion photoélectrique exécute le procédé selon la revendication 12.

14. Programme informatique pour qu'un dispositif de conversion photoélectrique exécute le procédé selon la revendication 12.
